# EUROPEAN PATENT APPLICATION

(11) **EP 3 040 864 A1**
(43) Date of publication of application: **06.07.2016**
(21) Application number: 15200658.1
(22) Date of filing: 17.12.2015
(51) Int. Cl.: G06F 11/36, G06F 11/26

(54) **AIRCRAFT SIMULATION SYSTEM**

(30) Priority: 31.12.2014 US 201414587506
(71) Applicant: GE Aviation Systems LLC, Grand Rapids, MI 49512-1991 (US)
(72) Inventor: VOSSLER, Gerald Les, Grand Rapids, MI Michigan 49512-1934 (US); DEMARIA, Tom, Grand Rapids, MI Michigan 49512-1934 (US); BEATSON, Mark MacLean, Grand Rapids, MI Michigan 49512-1934 (US)
(74) Representative: Illingworth-Law, William Illingworth

(57) **Abstract**

An aircraft simulation system (10) for development of aircraft-specific application software (46) including at least one development node (16) running virtual software simulating an aircraft component having application software (46) and a processor configured to execute the application software (46), at least one non-development node in communication with an aircraft component (20), and a communications network (14) for interconnecting the at least one development node (16) and the at least one other node, wherein the aircraft simulation system (10) operates to simulate at least a portion of the aircraft component.

## Description

### BACKGROUND OF THE INVENTION

Software development for aircraft system components is a resource-intensive task. For example, some components may need to interact with other components in a known and defined process. In another example, different aircraft system component iterations may include different hardware iterations, which may drive changes in the software development. During software development, the software may need to be tested with additional aircraft components to ensure interoperability. Many of these components are made by different manufacturers spread across large geographic regions, and may be developed at different times, or during dissimilar development cycles. Thus, bringing together the many aircraft system components for development and/or testing a new or updated component may be difficult to accomplish in a practical manner. To assemble a full test system environment, each component manufacturer may need to wait until each component maker for the system has their respective component completed. Additionally, one or more software and/or hardware iterations may also need to obtain different levels of certification for use through a rigorous testing methodology.

### BRIEF DESCRIPTION OF THE INVENTION

In one aspect, an aircraft simulation system for development of aircraft-specific application software, includes at least one development node running virtual software simulating an aircraft component having a processor and development application software being executed on the processor, at least one non-development node in communication with a different, real aircraft component having a processor and non-development application software being executed on the processor, and a communications network interconnecting the at least one development node and the at least one non-development node, and configured to operate in real-time accordance with an aircraft network communications standard. The aircraft simulation system operates to simulate at least a portion of the aircraft component in real-time while executing the application software.

In another aspect, an aircraft simulation system for development of aircraft-specific application software, including at least one development node running virtual software simulating an aircraft component having a processor and development application software being executed on the processor, and located at one manufacturer location, at least one line-replaceable unit (LRU) of an aircraft that is manufactured by another manufacturer, and a communications network interconnecting the at least one development node and the at least one LRU, and configured to operate in real-time accordance with the ARINC 664 aircraft network communications standard. The aircraft simulation system operates to simulate at least a portion of the aircraft component in real-time while executing the application software.

### BRIEF DESCRIPTION OF THE DRAWINGS

In the drawings:
FIG. 1 is a schematic view of the aircraft simulation system in accordance with one embodiment of the invention.
FIG. 2 is a schematic view of a development node of the aircraft simulation system of FIG. 1.
FIG. 3 is a schematic view of the communications network configuration of FIG. 1.
FIG. 4 is a schematic view of a scalable aircraft simulation system node cluster in accordance with one embodiment of the invention.

### DESCRIPTION OF EMBODIMENTS OF THE INVENTION

The invention may be implemented in any environment using software and/or application development for any system or component. While this description is primarily directed toward an aircraft simulation system for developing aircraft-specific application software, it may also be applicable to developing application software for other environments and/or vehicles. For example, embodiments of the invention may be included in development systems such as power plant control, healthcare diagnostic software, general stationary industrial control, and/or operations software for any form of transportation or plant management.

While the description of the invention may refer to development or execution of "application software," embodiments of the invention may include development of any executable code or instruction set, computer program, software, module, routine, or the like. Moreover, the application software may include a computer program product that may include machine-readable media for carrying or having machine-executable instructions or data structures stored thereon. Generally, such application software may include objects, components, data structures, algorithms, etc. that have the technical effect of performing particular tasks or implement particular abstract data types. Machine-executable instructions, associated data structures, and programs represent examples of program code for executing the exchange of information as disclosed herein. Machine-executable instructions may include, for example, instructions and data, which cause a general purpose computer, special purpose computer, processor, special purpose processor, or special purpose processing machine to perform a certain function or group of functions.

Additionally, as used herein, "real" components include actual physical components that may be selectively coupled with a system to provide functionality and/or operation as intended in their natural utilized configuration. For example, a "real" primary flight display (PFD) is a line-replaceable unit (LRU) that may be physically installed and/or removed from an aircraft cockpit, and provides utilizable data and information for a pilot during aircraft operations. Also as used herein, and in contrast the "real" components, "simulated" components are not actual physical devices, but may be virtual embodiments and/or representations of the corresponding "real" counterparts, and may provide similar virtual or simulated functionality and/or operations, like their corresponding "real" counterparts.

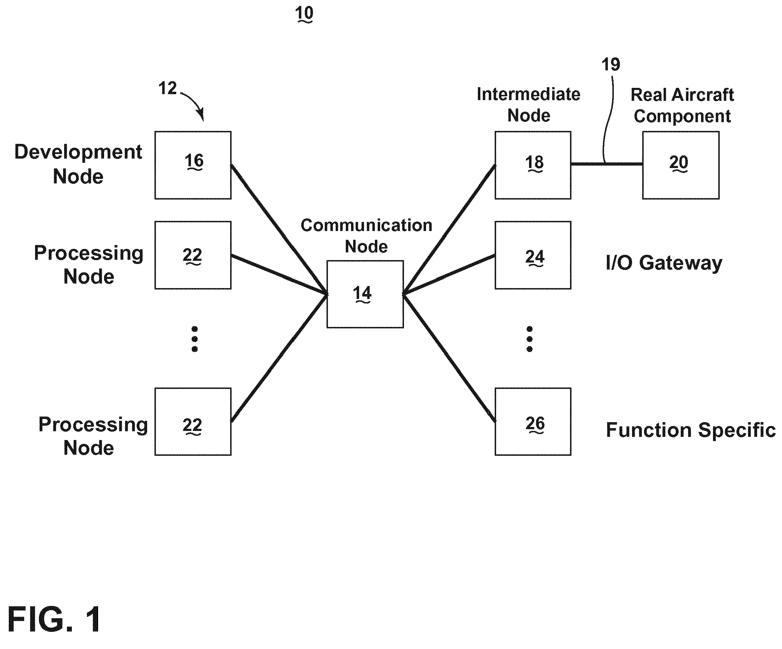

FIG. 1 illustrates an aircraft simulation system 10 for development of aircraft-specific application software. As shown, the simulation system 10 may include a plurality of nodes 12 interconnected via a communications network 14. The plurality of nodes 12 may include at least one development node 16 and at least one other node, such as an intermediate node 18, which may be configured to include communication with an actual aircraft component 20. The communication between the intermediate node 18 and the actual aircraft component 20 may include any compatible communications medium 19, for example, a universal connector, serial port, and/or a proprietary interface, as needed to communicatively couple the aircraft component 20 to the communications node 14, via the intermediate node 18. The simulation system 10 may optionally include additional nodes, for example, one or more processing nodes 22, input/output nodes and/or gateways 24, and/or function specific nodes 26. The example plurality of nodes 12 described herein are non-limiting examples of nodes 12 that may be included in embodiments of the invention. Furthermore, while the communications network 14 is illustrated as a single node, embodiments of the invention may include networks 14 that may include more than one node, network switch, and/or virtualized network components. Additional or alternate nodes 12 may be included.

The aircraft component 20 may include one or more real components used on an aircraft to provide optional or necessary functionality and/or operation for the aircraft simulation system 10. For example, the aircraft component 20 may include a real PFD, a real global positioning signal (GPS) unit, and/or real environmental sensors to provide optional and/or necessary inputs to the system 10, via the intermediate node 18 and/or communications node 14. While the aircraft component 20 is illustrated coupled with the communications node 14 via the intermediate node 18, embodiments of the invention may include examples wherein the aircraft component couples directly to the communications node 14. Additionally, the simulation system 10 may include one or more optional or necessary simulated components representing and/or simulating a representation of components used on an aircraft, to provide the simulated functionality and/or operation for the system 10. For example, the system 10 may utilize a processing node 22 and/or a function specific node 26 to simulate a virtual PFD, including performing functions just as a real PFD would perform. In another example, one or more function specific nodes 26 may be configured to, for example, simulate specific function or signal, such as GPS, and/or an environmental reading and/or signal from a virtual or simulated sensor. In this sense, the function specific nodes 26 may provide optional and/or necessary simulated inputs to the system 10, via the communications node 14. Additionally, one or more input/output gateways 24 may be configured to provide additional coupling mechanisms (real or virtual) for communicatively coupling additional real or simulated components, as needed for the proper functionality of the simulation system 10.

The simulation system 10 operates to provide for a suitable development environment for developing application software for an aircraft component in a non-aircraft setting, such as in a data cluster. In this sense, while the simulation system 10 simulates a 'real' aircraft, at least with respect to the aircraft system component or components related and/or necessary to the application software being developed, the actual development activities may occur away from the aircraft, such as a data cluster, server room, and/or third party site, where access to a aircraft or aircraft components may not be necessary.

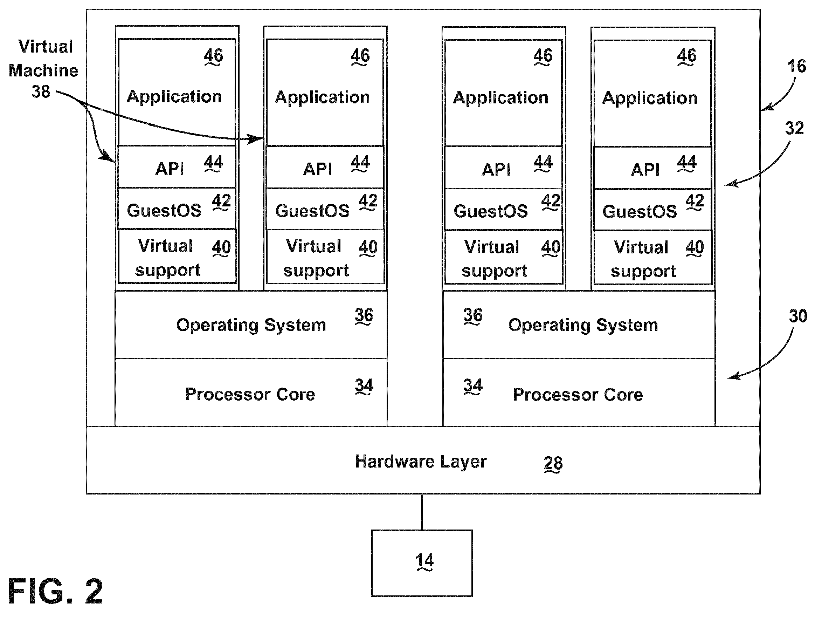

FIG. 2 schematically illustrates one example embodiment of a development node 16 for developing aircraft-specific application software. As shown, each development node 16 may comprise at least one abstract layer, such as a hardware layer 28, a processing layer 30, and/or an application layer 32. The hardware layer 28 may include support components for supporting the operation of each and/or both of the processing layer 30 and/or application layer 32. For example, the hardware layer 28 may include the necessary hardware and software to support a network interface with the communications network 14. Additionally, the hardware layer 28 may include memory and/or processor support that is accessible by the processing and application layers 30, 32 for operation of the development node 16. In one embodiment, the memory may include random access memory (RAM), read-only memory (ROM), flash memory, or one or more different types of portable electronic memory, such as discs, DVDs, CD-ROMs, etc., or any suitable combination of these types of memory.

The processing layer 30 may include one or more independent processer cores 34, supported by the hardware layer 28, and configured to provide independent execution of one or more application layer 32 software components. Each processor core 34 may execute a basic operating system 36 configured to provide for a suitable environment for executing software.

The application layer 32 may be further configured to execute at least one application software 46 component. As shown, the application layer 32 includes a number of virtual machine 38 configurations, wherein each processing layer 30 may operate multiple virtual machines 38. In one embodiment of the invention, each virtual machine 38 may comprise a virtual support layer 40 configured to provide for interaction between the machine 38 and processing layer 34 and/or hardware layer 28, a guest operating system 42 or virtual operating system configured to provide a suitable environment for execution of the software application 46, application programmable interfaces (APIs) 44 for accessing and/or translating interactions between the software application 46 and any lower-layer components, and the executable application software 46, itself. While the illustrated embodiment includes two processor cores 34, each running and/or executing two virtual software and/or virtual machine 38 instances, alternative configurations and/or components may be included. Moreover, unless otherwise described, particular component and/or layer examples for each of the hardware layer 28, processing layer 30, and/or application layer 32 are provided to describe one example embodiment of the invention, and are not germane to the invention. While several application software 46 instances are shown, one or more application software 46 instances may include development application software 46, while other virtual machines 38 may be, for example, simulating components of the aircraft system 10, as described herein.

While the hardware layer 28, processing layer 30, and application layer 32 are shown in the illustrated configuration, embodiments of the invention may include configurations wherein the processor core 34 may be operably coupled with the memory such that one of the processor core 34 and the memory may include all or a portion of the application software 46 for controlling the operation of the development node 16. Each development node 16 may comprise a general purpose or special purpose computer, for example, specific to the aircraft system 10 being simulated. Additionally, while FIG. 2 is shown illustrating a development node 16, FIG. 2 may also represent any of the additional plurality of nodes 12 in the system 10, such as the processing nodes 22.

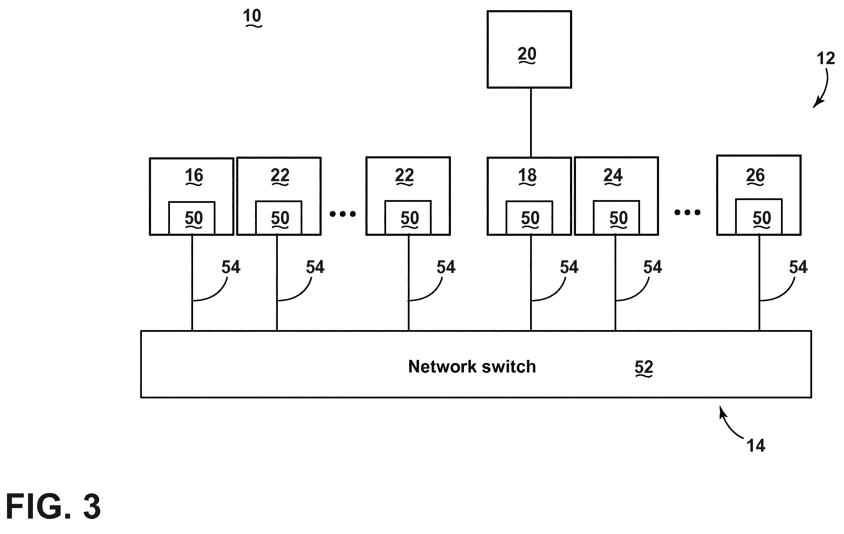

FIG. 3 illustrates an example communications network 14 for interconnecting the plurality of nodes 12. As shown, the communications network 14 may comprise at least one network switch 52 configured to facilitate the network-based switching communications of the simulation system 10, and a plurality of communication mediums, such as communication wires 54, configured to provide for individual communication between the at least one network switch 52 and each of the plurality of nodes 12. One non-limiting example of the communication wires 54 may include Ethernet, and additional examples may be included. Embodiments of the invention may include configurations wherein each of the plurality of nodes 12 further include a network interface 50 configured to couple with the communication wires 54, and provide for communication between, for example, the different abstract layers 28, 30, 32, or provide signals and/or data from each of the intermediate nodes 18, input/output gateways 24, and/or function specific nodes 26.

The communications network 14 may be further configured to operate in real-time accordance with a pre-defined compliant aircraft communications standard, for example, ARINC 664 part 7, ARINC 653, or future-developed standards, in order to provide an accurate simulation of a real aircraft communications network. In another example, the communications network 14 may further operate according to a pre-defined or future-developed wireless aircraft communications standard. Embodiments of the invention may include real network switches 52, redundant communication wires 54, etc., or in a wireless network 14, wireless access points, wireless nodes, etc., in accordance with the aircraft communications standard, in addition to, or in place of, simulating the aircraft communications network while utilizing conventional switches 52 and/or wires 54.

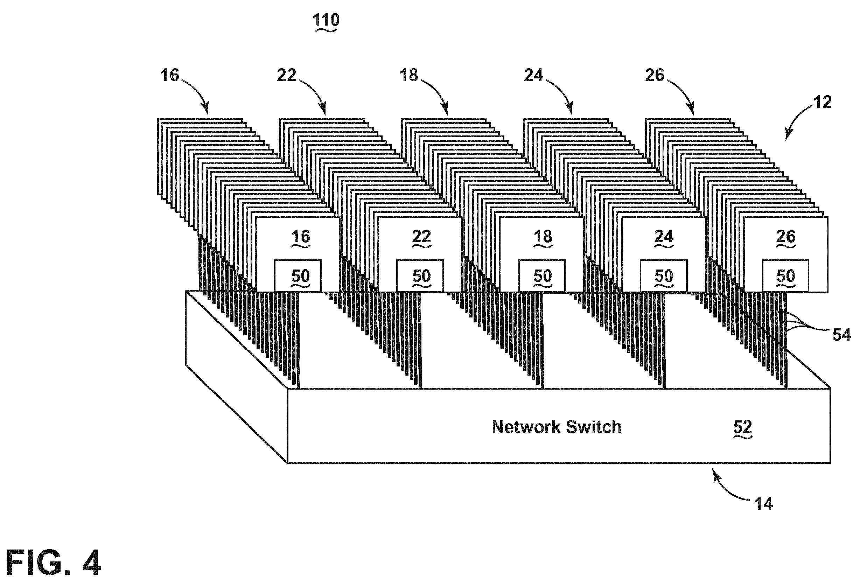

Turning now to FIG. 4, one embodiment of the invention is shown demonstrating the scalability of the simulation system 110. In this example, a number development nodes 16, processing nodes 22, intermediate nodes 18, input/output gateways 24, and function-specific nodes 26 are illustrated communicatively couple via communications network 14. In this example, the number of any one component may be varied according to the configuration of the aircraft component and/or aircraft system to be simulated, virtualized, and/or developed for (with respect to the application software 46). For example, a simulation system 110 may virtualize many aircraft components while in the early development stages of the application software 46, and thus, many development nodes 16 and processing nodes 22 may be included. In later development stages of the application software 46, a developer may want to use as many real aircraft components as possible to ensure interoperability, or for certification and/or regression testing, and thus may include more input/output gateways 24, function specific nodes 26, and/or intermediate nodes 18. Furthermore, each development node 16 may be interchangeable in the simulation system 110 such that different, updated, or new hardware, such as processor cores, may be modified as hardware is updated during the development process, and included for immediate development activities.

The embodiments disclosed herein provide an aircraft simulation system for development of aircraft-specific application software in a data center or data cluster. The technical effect is that the above described embodiments enable the centralized development of application software utilizing reconfigurable real and virtualized components configured to provide necessary support to faithfully execute at least a portion of the development application software while simulating at least a portion of the aircraft and/or aircraft components. For example, a developer may actively and rapidly develop auto-land software in the simulation system 10, 110 by utilizing test development application software 46 code in a development node 16 interacting with a plurality of other nodes 12, or non-virtual and/or non-development nodes, which for instance may be providing simulated inputs for the auto-land software, an aircraft-specific communication network 14, and a real PFD 20 coupled with an intermediate node 18. In another example, the other nodes 12 may further include a processor and non-development application software being executed on the processor. While one example development of auto-land application software 46 is described, many different development activities encompassing many different aircraft systems and/or aircraft components may be possible with the embodiments of the invention described herein.

In designing, developing, and /or testing application software for one or more aircraft components for a contemporary aircraft, the application software may need to be tailed to be used and/or communicate with many different aircraft components made by many different component manufacturers, for many different aircraft types and/or models. For example, the development node and/or application software may be located at, or developed by a first manufacturer, while the other node, or LRU may be manufactured by another manufacturer. Embodiments of the invention described herein provides for an aircraft simulation system wherein development of the aircraft-specific application software may be tailored to simulate many different aircraft components manufactured by different manufacturers and/or aircraft types to ensure an accurate development, testing, and/or communications environment without having to physically assemble each individual environment. In this sense, the aircraft simulation system may be dynamically reconfigured to simulate each environment, at the convenience of the development efforts, as needed.

Many other possible embodiments and configurations in addition to that shown in the above figures are contemplated by the present disclosure. For example, one embodiment of the invention contemplates an input/output gateway 24, intermediate node 18, and/or input/output physical coupling that may, for example, provide simple pass-through of a relevant signal or data, as needed for the simulation system 10, 110. Another example embodiment may include an input/output gateway 24, intermediate node 18, and/or input/output physical coupling that includes configurable capabilities to, for instance, translate and/or convert input data or input signals to a desired output communication compatible with the system 10, 110 and/or communications network 14.

Another embodiment may be included wherein a function specific node 26 may further comprise a signal-generating unit providing a simulated signal to the communications network 14 and/or another nodes 12, for example, directly, or via the communications network 14. In this embodiment, the simulated signal and/or simulated component may provide necessary support to faithfully execute the development application software 46. In yet another example embodiment, a function specific node 26 may further include memory having playback data recorded and/or simulated from a respective real aircraft component, such that the function specific node 26 may be configured to simulate the respective aircraft component by playing back the playback data, such as GPS data that may simulate a moving aircraft while the system 10, 110 remains fixed in a single location.

In yet another embodiment of the invention, the simulation system 10, 110 may include an additional error node configured to log data related to the simulation of the system 10, 110, such as communications on the communications network 14, errors generated by one or more components and/or nodes 12, and/or development application software interactions with one or more other components and/or nodes 12, or for recording, identifying and/or debugging the development application software. Alternatively, the functions and operations of the error node may be incorporated into the at least one development node 16, for example, as a sub-routine computer program, or within another virtual machine 38, for recording, identifying and/or debugging the development application software. Additional embodiments of error and/or debugging may be included, as are common for software development, and for example, may be included in each layer of each node 12, in each software module, and/or each hardware component.

One advantage that may be realized in the above embodiments is that the above-described embodiments provide for an agile and configurable development environment for development of application software for aircraft systems, as well as integration of complex embedded system interacting with said development application software. Another advantage is by utilizing a scalable environment with the aircraft-specific communications network, the simulation system is capable of simulating the behavior of the aircraft systems in question in real-time, allowing for improved accuracy of the development environment, and allowing for more accurate development of application software. Furthermore, by utilizing capabilities of coupling real aircraft components such as the PFD with the simulation system, the development application software may be capable of real-time interaction with a real aircraft device, further improving the development environment and generating better development application software.

Yet another advantage of the above-described embodiments is that the simulation system itself may be housed and/or contained in a location specifically designed to house such technology systems, such as a data center or server room, while remaining remotely-accessible to internal and external (e.g. third party) developers simultaneously. In this sense, the simulation system may be managed to provide timed assignments, scheduled development activities, and/or concurrent development (for example, utilizing multiple virtual instantiations of real and/or virtualized aircraft components) such that the system may provide batched development and/or testing to multiple users and/or parties, while providing a single accessible unit having associated costs. Thus, the development costs of developing integrated, wide ranging, or even limited aircraft systems may be shared or reduced (i.e. only paying for precise development time) compared to each developer having to bear the costs of their own development environment.

Yet another advantage of the above-described embodiments is that as development moves through development stages and hardware, software, and operating standards are revised, the simulation system nodes can provide a single point of replacement and/or updating. For example, if a hardware revision requires a new processor core, a new development node may be interchanged with the old node, and all developers having access to the simulation system may thus have access to the updated hardware. This provides reduced development inefficiencies and costs of distributing updated hardware to each developer.

Yet another advantage of the above-described embodiments may be capable of generating a simulation environment for development of application software that the simulation environment may be capable of providing a certification environment for the developed software as well. Certification of aircraft application software is a rigorous and expensive process, and having a reusable simulation environment may provide efficiency and cost savings over conventional certification testing methodology.

Each of the described embodiments addition provide for shorting development time, reducing development cost and reducing development risk for real-time, embedded systems. The embodiments may also reduce or eliminate the use of prototype and/or special to purpose hardware and/or software during development.

To the extent not already described, the different features and structures of the various embodiments may be used in combination with each other as desired. That one feature may not be illustrated in all of the embodiments is not meant to be construed that it may not be, but is done for brevity of description. Thus, the various features of the different embodiments may be mixed and matched as desired to form new embodiments, whether or not the new embodiments are expressly described. All combinations or permutations of features described herein are covered by this disclosure.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. An aircraft simulation system (10) for development of aircraft-specific application software, the system comprising:
at least one development node (16) running virtual software simulating an aircraft component having a processor and development application software being executed on the processor;
at least one non-development node (20) in communication with a different, real aircraft component having a processor and non-development application software being executed on the processor; and
a communications network (14) interconnecting the at least one development node and the at least one non-development node (20), and configured to operate in real-time accordance with an aircraft network communications standard;
wherein the aircraft simulation system (10) operates to simulate at least a portion of the aircraft component in real-time while executing the application software (46).

2. The simulation system of claim 1, wherein the aircraft network communications standard comprises ARINC 664 part 7.

3. The simulation system of claim 1 or claim 2, wherein each of the at least one development node and the at least one non-development node further comprises a networking interface configured to communicate with the communications network.

4. The simulation system of any preceding claim, wherein the at least one non-development node further comprises at least one of an input/output coupling, an input/output gateway, an intermediate node, or a function specific node.

5. The simulation system of any preceding claim, further comprising a signal-generating unit providing a simulated signal received by the communications network and wherein at least one of the input/output coupling or the input/output gateway is communicatively coupled with the signal-generating unit.

6. The simulation system of any preceding claim, wherein the one non-development node further comprises a line-replaceable unit (LRU) of an aircraft.

7. The simulation system of any preceding claim, wherein the LRU further comprises a primary flight display.

8. The simulation system of any preceding claim, further comprising at least one simulation node is configured to simulate at least one other aircraft component and providing necessary support to execute the application software.

9. The simulation system of any preceding claim, wherein the at least one simulation node further comprises simulation software configured to interact with at least one of the at least one development node, the communications network, or the at least one non-development node.

10. The simulation system of any preceding claim, wherein the at least one simulation node further comprises memory having playback data recorded from a respective aircraft component, and wherein the at least one simulation node is configured to simulate the respective aircraft component by playing back the playback data.

11. The simulation system of any preceding claim, further comprising at least one error node configured to log errors on the communications network.

12. The simulation system of any preceding claim, wherein the at least one development node further comprises error logging software configured for at least one of recording, identifying, or debugging application software operation.

13. The simulation system of any preceding claim, wherein the at least one development node further comprises at least one of a hardware layer, a processing layer, or an application layer.

14. The simulation system of any preceding claim, wherein the at least one development node further comprises a specific purpose processor.

15. An aircraft simulation system (10) for development of aircraft-specific application software (46), the system comprising:
at least one development node (16) running virtual software simulating an aircraft component having a processor and development application software being executed on the processor, and located at one manufacturer location;
at least one line-replaceable unit (LRU) of an aircraft that is manufactured by another manufacturer; and
a communications network (14) interconnecting the at least one development node and the at least one LRU, and configured to operate in real-time accordance with the ARINC 664 aircraft network communications standard;
wherein the aircraft simulation system (10) operates to simulate at least a portion of the aircraft component in real-time while executing the application software (46).
